# EUROPEAN PATENT APPLICATION

(11) **EP 4 765 316 A1**
(43) Date of publication of application: **24.06.2026**
(21) Application number: 25848864.2
(22) Date of filing: 28.07.2025
(51) Int. Cl.: H01M 10/42

(54) **BMS MANUFACTURING SYSTEM, BMS MANUFACTURING METHOD, AND BATTERY MANUFACTURING SYSTEM**

(30) Priority: 30.07.2024 KR 20240100851
(71) Applicant: LG Energy Solution, Ltd., Seoul 07335 (KR)
(72) Inventor: YU, Jae Wook, Daejeon 34122 (KR)
(74) Representative: Goddar, Heinz J.
(86) International application number: PCT/KR2025/011174
(87) International publication number: WO 2026/029515

(57) **Abstract**

According to some embodiments, a BMS manufacturing system include a coating device configured to apply a coating material to a battery management system (BMS) circuit including circuit components mounted on a circuit board, a curing device configured to irradiate a surface of the BMS circuit with curing light to cure the coating material, and an inspection device configured to cause heat generation of the BMS circuit by performing a functional inspection of the BMS circuit to perform heat treatment on a portion of the coating material not exposed to the curing light.

## Description

### TECHNICAL FIELD

### Cross-reference to Related Applications

This application claims priority from Korean Patent Application No. 10-2024-0100851, filed on July 30, 2024, the disclosure of which is incorporated by reference herein.

### Technical Field

Embodiments disclosed in this document relate to a battery management system (BMS) manufacturing system, a BMS manufacturing method, and a battery manufacturing system.

### BACKGROUND ART

Recently, research and development on secondary batteries have been actively conducted. Here, secondary batteries are batteries that can be charged and discharged, and may be interpreted as including both conventional Ni/Cd batteries, Ni/MH batteries, and recent lithium-ion batteries. Among secondary batteries, lithium-ion batteries can have higher energy density than conventional Ni/Cd batteries, Ni/MH batteries, etc., and may be manufactured in a small and lightweight form, and thus may have high utilization as a power source for mobile devices. Recently, the scope of use of the lithium ion batteries has expanded to include a power source for electric vehicles, and the lithium ion batteries are attracting attention as a next-generation energy storage medium.

A BMS may be utilized to control charging and discharging operations of battery cells and perform various management functions. A BMS circuit may be manufactured by mounting BMS components on a circuit board and then applying a polymer coating material to the components. A coating material applied to the BMS circuit may be cured using ultraviolet irradiation, etc. Curing of the coating material may require a separate heat treatment or natural drying treatment, which may be a factor that increases the manufacturing takt time of the BMS circuit.

### DISCLOSURE OF THE INVENTION

### TECHNICAL PROBLEM

Embodiments disclosed in this document provide a BMS manufacturing system, a BMS manufacturing method, and a battery manufacturing system that can perform curing of a coating material using a functional inspection step to improve the manufacturing efficiency of a BMS circuit.

The technical problems of the embodiments disclosed in this document are not limited to the technical problems mentioned above, and other technical problems that are not mentioned may be clearly understood by those skilled in the art from the descriptions below.

### TECHNICAL SOLUTION

According to some embodiments, a BMS manufacturing system include a coating device configured to apply a coating material to a battery management system (BMS) circuit including circuit components mounted on a circuit board, a curing device configured to irradiate a surface of the BMS circuit with curing light to cure the coating material, and an inspection device configured to cause heat generation of the BMS circuit by performing a functional inspection of the BMS circuit to perform heat treatment on a portion of the coating material not exposed to the curing light.

According to some embodiments, the coating material may include a photoinitiator, and the curing light includes ultraviolet light.

According to some embodiments, the photoinitiator applied to upper surfaces of the circuit components may be directly exposed to the ultraviolet light, and the photoinitiator applied to side surfaces and lower surfaces of the circuit components may be partially exposed to the ultraviolet light.

According to some embodiments, the circuit components may include a first component of a height directional extension type whose height relative to an area exceeds a first reference value, and a second component of an area directional extension type whose area relative to a height exceeds a second reference value.

According to some embodiments, the coating material applied to a side surface of the first component and the coating material applied to a lower surface of the second component may be further cured by heat generation of the BMS circuit.

According to some embodiments, the functional inspection may include at least one of a first inspection for a cell balancing function of the BMS circuit and a second inspection for a full computation function of the BMS circuit.

According to some embodiments, the BMS manufacturing system may further include a transfer device configured to sequentially transfer the BMS circuit to a battery packaging device through the coating device, the curing device, and the inspection device.

According to some embodiments, a BMS manufacturing method include applying, by a coating device, a coating material to a battery management system (BMS) circuit including circuit components mounted on a circuit board, irradiating, by a curing device, a surface of the BMS circuit with curing light to cure the coating material, and causing, by an inspection device, heat generation of the BMS circuit by performing a functional inspection of the BMS circuit to perform heat treatment on a portion of the coating material not exposed to the curing light.

According to some embodiments, the coating material may include a photoinitiator, and the curing light may include ultraviolet light.

According to some embodiments, the photoinitiator applied to upper surfaces of the circuit components may be directly exposed to the ultraviolet light, and the photoinitiator applied to side surfaces and lower surfaces of the circuit components may be partially exposed to the ultraviolet light.

According to some embodiments, the circuit components may include a first component of a height directional extension type whose height relative to an area exceeds a first reference value, and a second component of an area directional extension type whose area relative to a height exceeds a second reference value.

According to some embodiments, the coating material applied to a side surface of the first component and the coating material applied to a lower surface of the second component may be further by heat generation of the BMS circuit.

According to some embodiments, the functional inspection may include at least one of a first inspection for a cell balancing function of the BMS circuit and a second inspection for a full computation function of the BMS circuit.

According to some embodiments, the BMS manufacturing method may further include sequentially transferring, by a transfer device, the BMS circuit to a battery packaging device through the coating device, the curing device, and the inspection device.

According to some embodiments, a battery manufacturing system includes a printing device configured to form a battery management system (BMS) circuit by mounting circuit components on a circuit board, a BMS manufacturing system configured to apply a coating material to the BMS circuit, irradiate a surface of the BMS circuit with curing light to cure the coating material, and cause heat generation of the BMS circuit by performing a functional inspection of the BMS circuit to perform heat treatment on a portion of the coating material not exposed to the curing light, and a packaging device configured to package the BMS circuit that has passed the functional inspection together with a battery.

### ADVANTAGEOUS EFFECTS

According to the embodiments disclosed in this document, a BMS manufacturing system, a BMS manufacturing method, and a battery manufacturing system that can perform curing of a coating material using a functional inspection step to improve the manufacturing efficiency of a BMS circuit can be provided.

The technical effects according to the embodiments disclosed in this document are not limited to the effects mentioned above, and other effects that are not mentioned will be clearly understood by those skilled in the art according to the disclosure of this document.

### BRIEF DESCRIPTION OF THE DRAWINGS

FIG. 1 illustrates elements of a battery manufacturing system according to some embodiments.
FIG. 2 illustrates elements s of a BMS manufacturing system according to some embodiments.
FIGS. 3 and 4 illustrate a conventional technique for applying a coating material to a BMS circuit and curing the coating material.
FIGS. 5 and 6 illustrate a method for further curing uncured coating material using heat generated through a functional inspection of a BMS circuit according to some embodiments.
FIG. 7 illustrates steps constituting a BMS manufacturing method according to some embodiments.

### MODE FOR CARRYING OUT THE INVENTION

Hereinafter, embodiments described in this document will be described with reference to the accompanying drawings. However, this is not intended to limit the disclosure of this document to a specific embodiment, but should be understood to include various modifications, equivalents, and/or alternatives of the embodiments described in this document.

It should be understood that embodiments of this document and the terminology used therein are not intended to limit the technical features described in this document to specific embodiments, but rather to encompass various modifications, equivalents, or alternatives of the embodiments. In connection with the description of the drawings, similar reference numerals may be used for similar or related components. The singular form of a noun corresponding to an item may include one or more of said item, unless the relevant context clearly indicates otherwise.

In this document, each of phrases "A or B", "at least one of A and B", "at least one of A or B", "A, B, or C", "at least one of A, B, and C", and "at least one of A, B, or C" may include any one of the items listed together in that phrase among the phrases, or all possible combinations thereof. Terms such as "first", "second", or "firstly" or "secondly" may be used merely to distinguish one component from another, and, unless otherwise specifically stated, do not limit the components in any other respect (e.g., importance or order). Terms such as "first", "second", or "firstly" or "secondly", "A", "B", "(a)" or "(b)" may be used merely to distinguish one component from another, and, unless otherwise specifically stated, do not limit the components in any other respect (e.g., importance or order).

In this document, when a component (e.g., a first component) is referred to as being "coupled", "connected", or "joined" to another component (e.g., a second component), with or without the terms "functionally" or "communicatively", it means that the component can be connected to the other component directly (e.g., in a wired manner or wirelessly) or indirectly (e.g., through a third component).

The method according to various embodiments disclosed in this document may be provided by being included in a computer program product. The computer program product may be traded between a seller and a buyer as a product. The computer program product may be distributed in the form of a machine-readable storage medium (e.g., a compact disc read only memory (CD-ROM)), or may be distributed online (e.g., downloaded or uploaded) through an application store or directly between two user devices. In the case of online distribution, at least a part of a computer program product may be temporarily stored or temporarily generated in a machine-readable storage medium such as a memory of a manufacturer's server, an application store's server, a relay server.

According to the embodiments disclosed in this document, each component (e.g., a module or a program) of the components described above may include a single or a plurality of entities, and some of the plurality of entities may be separated and placed in other components. According to the embodiments disclosed in this document, one or more of the components described above among the components or operations may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to the embodiments disclosed in this document, the operations performed by a module, program, or other component may be performed sequentially, in parallel, repeatedly, or heuristically, or one or more of the operations may be performed in a different order, omitted, or performed by adding one or more other operations.

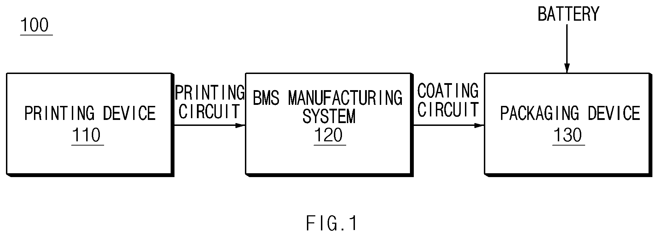

FIG. 1 illustrates elements constituting a battery manufacturing system according to some embodiments.

Referring to FIG. 1, a battery manufacturing system 100 may include a printing device 110, a BMS manufacturing system 120, and a packaging device 130. However, it is not limited thereto, and some configurations may be omitted from the battery manufacturing system 100, or other configurations may be additionally included in the battery manufacturing system 100.

The battery manufacturing system 100 may manufacture a battery pack. The battery manufacturing system 100 may produce the battery pack by performing packaging for a BMS circuit and a battery. The BMS circuit may be manufactured by the printing device 110 and the BMS manufacturing system 120.

The printing device 110 may produce a printed circuit using a PCB printing technique. The printed circuit may include circuit components mounted on a circuit board. The BMS manufacturing system 120 may perform post-processing on the printed circuit to produce the BMS circuit. Post-processing for the printed circuit may include conformal coating, curing treatment of the coating material, etc. When the BMS circuit is completed, the packaging device 130 may package the BMS circuit and the battery to form a battery pack.

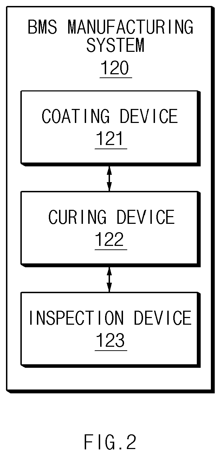

FIG. 2 illustrates elements constituting a BMS manufacturing system according to some embodiments.

Referring to FIG. 2, the BMS manufacturing system 120 may include a coating device 121, a curing device 122, and an inspection device 123. However, it is not limited thereto, and some configurations may be omitted from the BMS manufacturing system 120, or other configurations may be additionally included in the BMS manufacturing system 120.

The coating device 121 may perform conformal coating on the BMS circuit. Conformal coating may include applying components mounted on a circuit board with a coating material, such as a polymer, to protect the components and ensure smooth operation. The coating device 121 may include means for spraying, brushing, or depositing a coating solution.

The curing device 122 may cure the coating material applied to the circuit board and circuit components of the BMS circuit. The curing device 122 may irradiate the coating material with light, such as ultraviolet (UV), to induce a chemical reaction in the coating material, thereby increasing the hardness of the coating material. The curing device 122 may include a structure, such as a lamp or light source, for emitting light, such as UV.

The inspection device 123 may perform inspections on the functions of the BMS circuit. The BMS circuit is mounted on the battery pack to measure states of battery cells to generate battery data. The BMS circuit may perform various processing on the battery data to perform charge/discharge control, battery cell balancing, battery cell state diagnosis, battery status indicator computation, etc. Whether the functions of the BMS circuit are operating normally may be inspected by the inspection device 123. According to the embodiment, heat may be generated from the circuit board and circuit components by the functional inspection of the BMS circuit, which may be used to further cure the coating material that has not yet been cured. The inspection device 123 may include control means and/or processing means for directing the operation of the BMS circuit.

The coating device 121 may be configured to apply the coating material to the BMS circuit including circuit components mounted on a circuit board. The coating device 121 may include means for applying the coating material, through which the coating material may be sprayed, brushed, or deposited onto the circuit board and circuit components. The coating of the coating device 121 may be a conformal coating for protecting a printed circuit board (PCB). The coating material may be acrylic, polyurethane, silicone, urethane, epoxy, or a combination thereof.

The curing device 122 may be configured to irradiate a surface of the BMS circuit with curing light to cure the coating material. The curing device 122 may include a lamp, light source, etc. for generating light of a specific frequency, and may use this to irradiate the coating material with curing light. The curing light may induce a reaction of the coating material to change its arrangement structure, physical properties, etc. When the coating material is irradiated with the curing light, the hardness and strength of the coating material may increase.

The inspection device 123 may be configured to perform a functional inspection of the BMS circuit to perform heat treatment on a portion of the coating material that is not exposed to curing light, thereby causing heat generation in the BMS circuit. When the functional inspection is performed on the BMS circuit, the circuit components of the BMS circuit may perform computational tasks, which may cause heat to be generated from the circuit board and the circuit components. Portions of the coating material that are not directly exposed to curing light may not yet be fully cured and may be further cured by heat generation of the BMS circuit. According to the embodiment, the functional inspection of the BMS circuit may be performed at a higher level than the level of a conventional product inspection, which may cause the BMS circuit to dissipate a greater amount of heat.

According to the embodiment, the coating material may include a photoinitiator, and the curing light may include ultraviolet light. Ultraviolet (UV) light may supply energy to the photoinitiator in the coating material, and the photoinitiator may convert monomers or oligomers in the coating component that have not yet become polymers into polymers. The conformal coating technique using the photoinitiator and UV light can shorten the time required for coating curing, thereby achieving high productivity. Meanwhile, since the conformal coating technique does not use diluents or solvents, it can be classified as an eco-friendly coating method.

According to the embodiment, the photoinitiator applied to the upper surface of the circuit components may be directly exposed to ultraviolet light, while the photoinitiator applied to the side surfaces and lower surfaces of the circuit components may be partially exposed to ultraviolet light. For the efficiency of a curing process using UV light, the UV lamp/light source may emit UV light in one predetermined direction. Therefore, unlike the upper surfaces of circuit components, which are directly exposed to UV light, the coating material applied to the side surfaces and lower surfaces thereof may be incompletely cured.

According to the embodiment, the circuit components may include a first component of a height directional extension type whose height relative to an area exceeds a first reference value, and a second component of an area directional extension type whose area relative to a height exceeds a second reference value. The efficiency of curing by UV light may vary depending on a structure or shape of the circuit components. A first component having a relatively large height or a second component having a relatively large area may have areas that are not exposed to UV light, and in these cases, some of the coating material may remain uncured. According to the embodiment, the first component may include a capacitor element or the like having a large height relative to its area structurally, and the second component may include an MCU chip, a processor chip, or the like configured to have a large area for high cooling efficiency.

According to the embodiment, the coating material applied to the side surface of the first component and the coating material applied to the lower surface of the second component may be further cured by heat generation of the BMS circuit. When the functional inspection is performed, the BMS circuit may perform computational processing, and heat may be generated from the substrate and components of the BMS circuit due to the computational processing. This heat generation may replace the heat curing process and/or natural drying process, which are separately performed to completely cure the uncured coating material. That is, it may be possible to omit the heat curing process and/or natural drying process by utilizing heat generation in the functional inspection.

According to the embodiment, the functional inspection may include at least one of a first inspection for a cell balancing function of the BMS circuit and a second inspection for a full computation function of the BMS circuit. The functional inspection may include a type of inspection that causes heat generation of the circuit board and circuit components. For example, the cell balancing function and full computation function may generate a large amount of heat, and thus, these inspections may be utilized for additional curing of the coating material. According to the embodiment, the functional inspection for the BMS circuit may be performed at a higher level than typical shipping performance testing and may induce a higher level of heat generation.

According to the embodiment, the BMS manufacturing system 120 may further include a transfer device configured to sequentially transfer the BMS circuit to the battery packaging device 130 through the coating device 121, the curing device 122, and the inspection device 123. For example, the transfer device may include a transfer means, such as a conveyor belt, and/or a holding means, such as a robot arm. When further curing of the uncured coating material is completed along with the functional inspection in the inspection device 123, the BMS circuit may be transferred to the packaging device 130 instead of being transferred to a heat treatment device or a natural drying device. That is, as the inspection device 123 performs the additional drying, the heat treatment process and/or the natural drying process may be omitted.

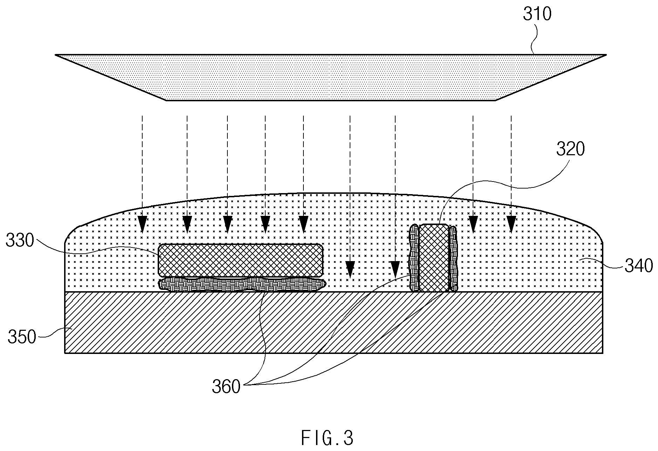

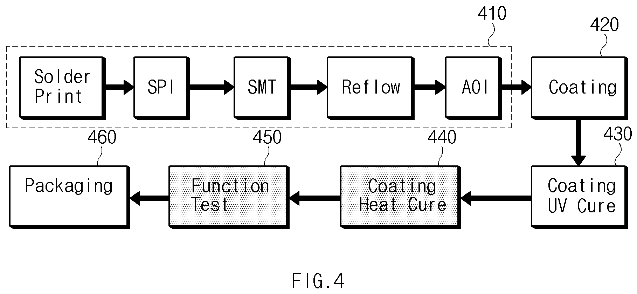

FIGS. 3 and 4 illustrate a conventional technique for applying a coating material to a BMS circuit and curing the coating material.

Referring to FIG. 3, a conventional technique for applying the coating material to the BMS circuit and curing the coating material may be illustrated. A coating material 340 may be applied to a first component 320, a second component 330, and a circuit board 350, and a UV lamp 310 may cure the coating material 340.

An uncured material 360 may not be directly exposed to curing light of the UV lamp 310. The uncured material 360 may be present on side surfaces of the first component 320 and a lower surface of the second component 330. The conventional technique may additionally perform a heat curing treatment and/or a natural drying treatment prior to the packaging process to perform additional curing on the uncured material 360.

Referring to FIG. 4, a flow of the conventional technique for applying the coating material to the BMS circuit and curing the coating material may be illustrated. The conventional technique may sequentially perform PCB printing 410, coating 420, UV curing 430, heat curing 440, functional inspection 450, and packaging 460.

The PCB printing 410 may include solder printing, solder paste inspection (SPI), surface-mount technology (SMT), reflow work, and automated optical inspection (AOI). In the conventional technique, the heat curing 440 may be included between the UV curing 430 and the functional inspection 450. Alternatively, in the conventional technique, a natural drying treatment process may be included in place of the heat curing 440. The natural drying treatment process of the conventional technique may take a long time, typically 7 to 14 days at room temperature, thereby significantly reducing manufacturing efficiency. On the other hand, the BMS manufacturing system 120 may not include the heat curing 440 and/or the natural drying treatment process.

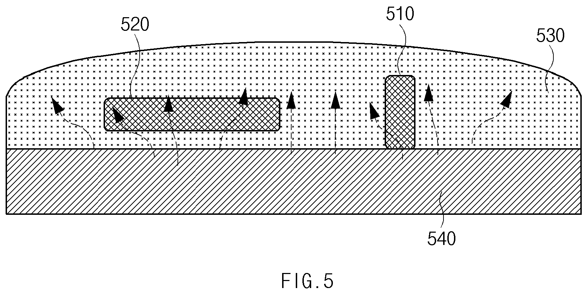

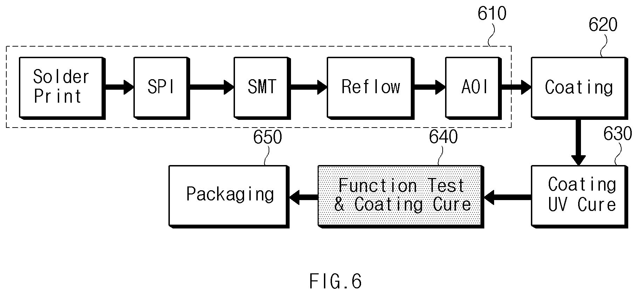

FIGS. 5 and 6 illustrate a method for additionally curing uncured coating material using heat generated through a functional inspection of a BMS circuit according to some embodiments.

Referring to FIG. 5, a method for additionally curing the uncured coating material using heat generated through the functional inspection of the BMS circuit may be illustrated. Uncured portions of a coating material 530 applied to side surfaces of a first component 510 or a lower surface of a second component 520 may be additionally cured by heat generated by a circuit board 540 and/or circuit components.

A functional inspection may be essentially performed to determine whether basic functions of the BMS circuit are operating normally. When utilizing some of the inherent functions of the BMS circuit, such as cell balancing or MCU full computation, which may increase the ambient temperature, subsequent heat curing may be performed simultaneously on areas that remain uncured after UV curing. Since this may does not require an additional process, the manufacturing takt time of the BMS circuit can be reduced.

Referring to FIG. 6, an operational sequence of the BMS manufacturing system 120 may be illustrated. The BMS manufacturing system 120 may perform coating 620, UV curing 630, and functional inspection 640 on a BMS circuit generated by PCB printing 610, and packaging 650 may be performed on the BMS circuit that has undergone the functional inspection 640.

In the BMS manufacturing system 120, the functional inspection 640 may be performed together with additional curing on the uncured coating material. The functional inspection 640 may be performed by implementing a self-heating function in software, enabling subsequent heat curing to be performed without separate curing equipment or facilities. As a result, the number of processes may be reduced, and equipment investment costs may be reduced. The self-heating function implemented in software does not affect the performance of the BMS circuit and may be performed during the functional inspection of the end-of-line (EOL) stage. The self-heating function may be performed within a normal operating temperature range. For example, the self-heating function may be performed at a temperature of approximately 60 degrees within the normal operating temperature range.

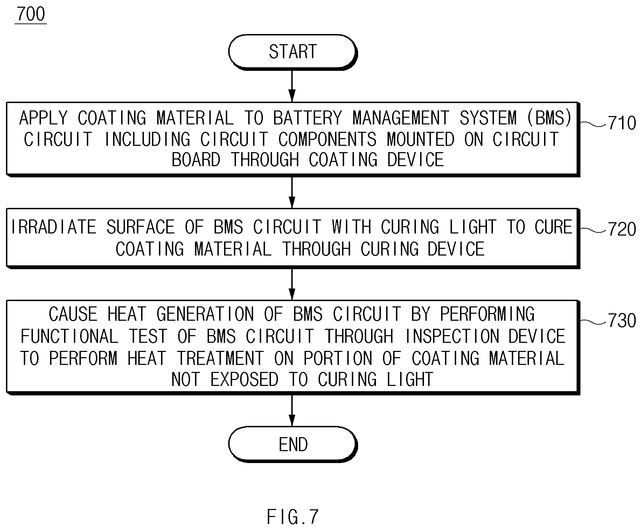

FIG. 7 illustrates steps constituting a BMS manufacturing method according to some embodiments.

Referring to FIG. 7, a BMS manufacturing method 700 may include steps 710 to 730. However, the present invention is not limited thereto. Some steps may be omitted or other general steps may be added, and the steps of the BMS manufacturing method 700 may be executed in a different order from the illustrated order.

The BMS manufacturing method 700 may be constituted by steps processed in a time series in the BMS manufacturing system 120. Therefore, even if the content is omitted below, the content described above for the BMS manufacturing system 120 may be equally applied to the BMS manufacturing method 700.

Steps 710 to 730 of the BMS manufacturing method 700 may be performed by the coating device 121, curing device 122, and inspection device 123 of the BMS manufacturing system 120.

In step 710, the BMS manufacturing system 120 may perform applying a coating material to a battery management system (BMS) circuit including circuit components mounted on a circuit board through the coating device.

In step 720, the BMS manufacturing system 120 may irradiate the surface of the BMS circuit with curing light to cure the coating material through the curing device.

In step 730, the BMS manufacturing system 120 may perform causing heat generation of the BMS circuit by performing a functional inspection of the BMS circuit through the inspection device to perform heat treatment on portions of the coating material not exposed to the curing light.

According to the embodiment, the battery manufacturing method 700 may be implemented in the form of a computer program stored in a computer-readable storage medium. That is, the computer program may include instructions for implementing the battery manufacturing method 700, and the instructions of the program may be stored in the computer-readable storage medium. The computer program may include a mobile application.

According to the embodiment, the computer-readable storage medium may include magnetic media such as hard disks, floppy disks, and magnetic tapes, optical media such as CD-ROMs, DVDs, magneto-optical media such as floptical disks, and hardware devices specifically configured to store and execute computer program instructions such as ROMs, RAMs, flash memory, and the like. The computer program instructions may include machine language code generated by a compiler and high-level language code that can be executed by a computer using an interpreter, etc.

The terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above description is merely an illustrative description of the technical idea disclosed in this document, and those skilled in the art to which the embodiments disclosed in this document belong may make various modifications and variations thereto without departing from the essential characteristics of the embodiments disclosed in this document. Accordingly, the embodiments disclosed in this document are intended to describe rather than limit the technical ideas of the embodiments disclosed in this document, and the scope of the technical ideas disclosed in this document is not limited by these embodiments. The scope of protection of the technical ideas disclosed in this document should be interpreted in accordance with the scope of the claims below, and all technical ideas within the equivalent scope should be interpreted as being included in the scope of rights of this document.

## Claims

1. A BMS manufacturing system, comprising:
a coating device configured to apply a coating material to a battery management system (BMS) circuit including circuit components mounted on a circuit board;
a curing device configured to irradiate a surface of the BMS circuit with curing light to cure the coating material; and
an inspection device configured to cause heat generation of the BMS circuit by performing a functional inspection of the BMS circuit to perform heat treatment on a portion of the coating material not exposed to the curing light.

2. The BMS manufacturing system of claim 1, wherein the coating material includes a photoinitiator, and the curing light includes ultraviolet light.

3. The BMS manufacturing system of claim 2, wherein, the photoinitiator applied to upper surfaces of the circuit components is directly exposed to the ultraviolet light, and
the photoinitiator applied to side surfaces and lower surfaces of the circuit components may be partially exposed to the ultraviolet light.

4. The BMS manufacturing system of claim 3, wherein the circuit components include a first component of a height directional extension type whose height relative to an area exceeds a first reference value and a second component of an area directional extension type whose area relative to a height exceeds a second reference value.

5. The BMS manufacturing system of claim 4, wherein the coating material applied to a side surface of the first component and the coating material applied to a lower surface of the second component are further cured by heat generation of the BMS circuit.

6. The BMS manufacturing system of claim 1, wherein the functional inspection includes at least one of a first inspection for a cell balancing function of the BMS circuit and a second inspection for a full computation function of the BMS circuit.

7. The BMS manufacturing system of claim 1, further comprising; a transfer device configured to sequentially transfer the BMS circuit to a battery packaging device through the coating device, the curing device, and the inspection device.

8. A battery management system (BMS) manufacturing method, comprising:
applying, by a coating device, a coating material to a battery management system (BMS) circuit including circuit components mounted on a circuit board;
irradiating, by a curing device, a surface of the BMS circuit with curing light to cure the coating material; and
causing, by an inspection device, heat generation of the BMS circuit by performing a functional inspection of the BMS circuit to perform heat treatment on a portion of the coating material not exposed to the curing light.

9. The BMS manufacturing method of claim 8, wherein the coating material includes a photoinitiator, and
the curing light includes ultraviolet light.

10. The BMS manufacturing method of claim 9, wherein the photoinitiator applied to upper surfaces of the circuit components is directly exposed to the ultraviolet light, and
the photoinitiator applied to side surfaces and lower surfaces of the circuit components is partially exposed to the ultraviolet light.

11. The BMS manufacturing method of claim 10, wherein the circuit components include a first component of a height directional extension type whose height relative to an area exceeds a first reference value, and a second component of an area directional extension type whose area relative to a height exceeds a second reference value.

12. The BMS manufacturing method of claim 11, wherein the coating material applied to a side surface of the first component and the coating material applied to a lower surface of the second component are further by heat generation of the BMS circuit.

13. The BMS manufacturing method of claim 8, wherein the functional inspection includes at least one of a first inspection for a cell balancing function of the BMS circuit and a second inspection for a full computation function of the BMS circuit.

14. The BMS manufacturing method of claim 8, further comprising:
sequentially transferring, by a transfer device, the BMS circuit to a battery packaging device through the coating device, the curing device, and the inspection device.

15. A battery manufacturing system comprising:
a printing device configured to form a battery management system (BMS) circuit by mounting circuit components on a circuit board;
a BMS manufacturing system configured to apply a coating material to the BMS circuit, irradiate a surface of the BMS circuit with curing light to cure the coating material, and cause heat generation of the BMS circuit by performing a functional inspection of the BMS circuit to perform heat treatment on a portion of the coating material not exposed to the curing light; and
a packaging device configured to package the BMS circuit that has passed the functional inspection together with a battery.
